## Europäisches Patentamt

## European Patent Office

## Office européen des brevets

(11) Publication number: **0 041 668**
**A2**

# EUROPEAN PATENT APPLICATION

(21) Application number: **81104152.4**

(22) Date of filing: **01.06.81**

(51) Int. Cl.³: **H 04 B 9/00**
**H 01 L 31/12**

(30) Priority: **09.06.80 SE 8004278**

(43) Date of publication of application:
**16.12.81 Bulletin 81/50**

(84) Designated Contracting States:
**CH DE FR GB IT LI**

(71) Applicant: **ASEA AB**

**S-721 83 Västeras(SE)**

(72) Inventor: **Adolfsson, Morgan**
**S. Edströms gata 86**
**S-724 66 Västeräs(SE)**

(72) Inventor: **Brogärdh, Torgny**
**Plätverksgatan 140**
**S-724 74 Västeräs(SE)**

(72) Inventor: **Göransson, Sture**
**Klockartorpsgatan 44 C**
**S-723 44 Västeräs(SE)**

(72) Inventor: **Ovren, Christer**
**Vilddjursvägen 9**
**S-722 43 Västeräs(SE)**

(74) Representative: **Boecker, Joachim, Dr.-Ing.**
**Rathenauplatz 2-8**
**D-6000 Frankfurt a.M. 1(DE)**

(54) Fiber optical measuring device.

(57) The invention relates to a fiber optical measuring device with a transducer section (5, 6, 7) comprising an optically supplied electronic system (7), the supply power and the measuring signal being arranged to be transmitted on the same light guide fiber (4), the device comprising light-emitting diodes (2, 5) and photo-diodes (3, 6). The invention is characterized in that the light-emitting diode (5) for transmission of the measuring signal is transparent to the light wavelength ($\lambda_1$), which is used for supplying the photo-diode (6) for the power supply, and that this light-emitting diode (5) is located in the optical path between the end of the fiber (4) and the photo-diode (6) receiving the optical supply power, and/or that the photo-diode (3) for receiving the measuring signal is transparent to the light wavelength ($\lambda_1$) that is used for the supply power, this photo-diode (3) being positioned between the other end of the fiber (4) and the light-emitting diode (2) which emits the supply power. The invention allows the use of the same light guide fiber (4) for transmitting the measuring signal and the supply signal without the need for fiber branches.

FIG.1

Patentanwalt und Rechtsanwalt
Dr.-Ing. Dipl.-Ing. Joachim B o e c k e r

**0041668**

6 Frankfurt/Main 1 , May 25, 1981
Rathenauplatz 2 - 8
Telefon: (06 11) * 28 23 55      B/th 20 945 PE
Telex: 4 189 066 itax d

A S E A    Aktiebolaget, Västeras/Sweden

## Fiber Optical Measuring Device

The invention relates to a fiber optical measuring device according to the prior art portion of claim 1.

When using optically fed electronic equipment for measuring purposes, the supply power is transmitted to the transducer side in the form of light, while at the same time the measuring signal in coded state is transmitted in the other direction. In such cases, there are often used separate optical fibers for the signals to and from the transducer side. This is disadvantageous because of the requirement of large amounts of fiber material. Therefore, the technic was developed using only partially separate fibers. This technic involves the use of fiber branches, which increases the cost and/or increases the light losses, which may also lead to certain error sources.

The invention aims at developing a fiber optical measuring device of the above-mentioned kind which is sheap and at the same time reliable and does away with the need for fiber branches.

In order to achieve this aim the invention suggests a fiber optical measuring device of the above-mentioned

/2

- 2 -

kind, which is characterized by the features of the characterizing portion of claim 1.

Further embodiments of the invention are characterized by
the features of the other claims.

The fiber optical measuring device according to the invention allows to transmit the two light signals (measuring signal and supply signal) in a simple and reliable
manner on the same light guide fiber. By doing away with
a need for costly fiber branches in inexpensive and
efficient measuring device is obtained.

The principle of the invention is based on the fact that
semiconductor materials with the band-gap $E_g$ have a very
low absorption to light with a wavelength $\lambda > hc/E_g$, where
$E_g$ is the energy needed for an electron to pass from a
valence band to a conduction band ($E_g$ determines the sensitivity of a photo-diode), c is the speed of light and
$\lambda$ is the wavelength. By making the light-emitting diode
and the photo-diode for the measuring signal transmission
of a semiconductor material, which is transparent to the
light that is used for transmitting the supply power, the
supply light can pass the components employed for the
measuring signal transmission, and these components can
therefore be located nearest to the fiber. Thus, the
device according to the invention constitutes a solution
to a problem which was previously considered as awkward.

The invention will be described in greater detail with
reference to the accompanying drawings, in which

 Figure 1 shows a simple embodiment of the invention
      demonstrating the principle of the invention,

 Figure 2 shows the wavelength conditions of different
      components in the arrangement according to
      Figure 1,

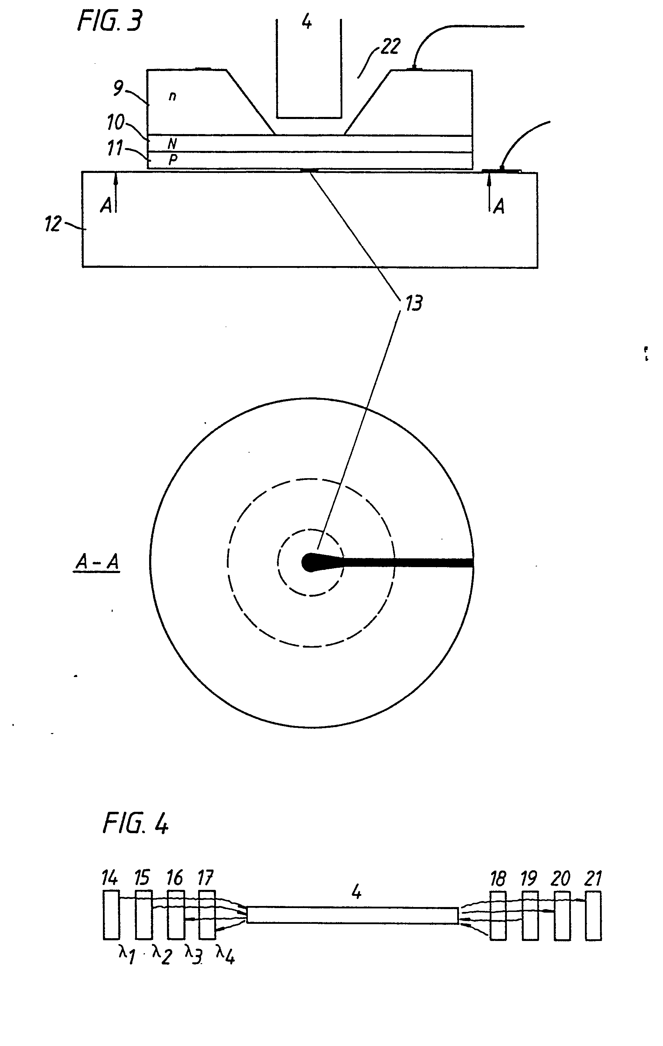

 Figure 3 shows the embodiment of a suitable structure according to the invention and a section along the line A-A in the upper part of this Figur, Figure 4 shows an embodiment of the invention having two or more channels in either direction.

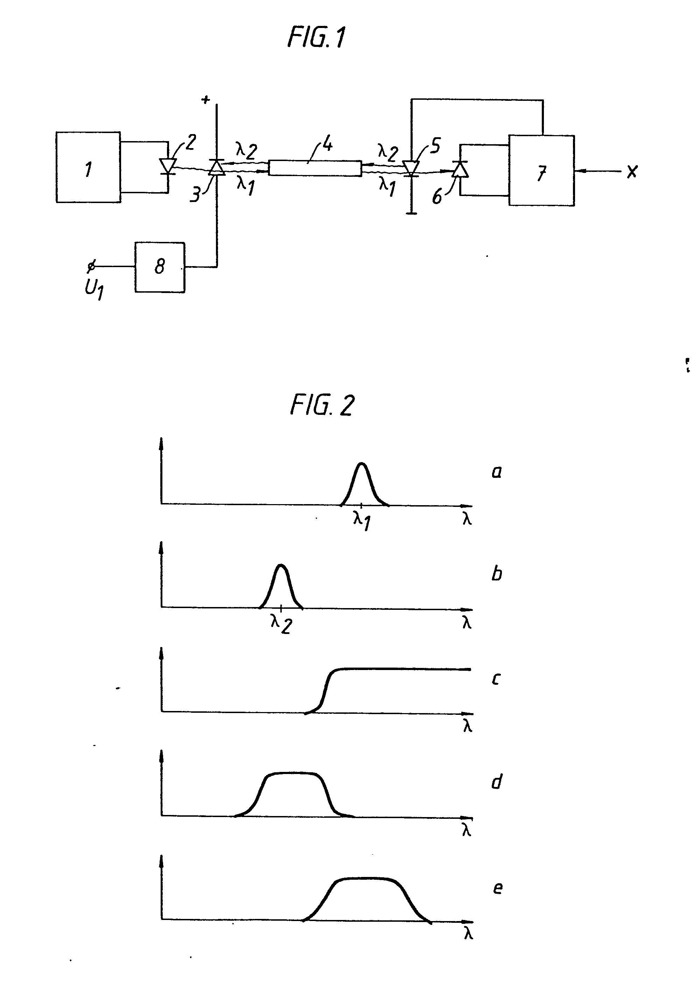

In Figure 1, a source of current 1 drives a current through a light-emitting diode 2 (LED). This causes the light emitting diode 2 to emit light of the wavelength $\lambda_1$, which passes through a transparent photodiode 3, a light guide fiber 4 common to the whole device, a light-emitting diode 5, which is also transparent and illuminates one or more photodiodes 6. The output signal from the photo-diode/photo-diodes 6 provides supply power to the electronic circuit 7, the function of which is to transform a measuring signal x into a coded signal which supplies current through the light-emitting diode 5. The electronic circuit 7 may be a so-called microcircuit and is kept well enclosed and protected. The modulated light from the light-emitting diode 5 constitutes a coding of the measuring signal x and is transmitted via the light guide fiber 4 to the photo-diode 3, the photo-current of which after evaluation in an evaluation electronic circuit 8 gives the output signal $U_1$. The light-emitting diodes 3 and 5 are transparent to the supply light from diode 2 with the wavelength $\lambda_1$. The wavelength of the measuring signal is $\lambda_2$, and as will be seen, both the supply and measuring signal are transmitted in one and the same light guide fiber. The light-emitting diode 2 radiates light of high intensity into the fiber 4. The emission spectrum for the light-emitting diode 2 is shown in Figure 2a, which shows that the intensity maximum lies at the wavelength $\lambda_1$. At this wavelength the photo-diode 6 shall have a high efficiency. The spectral sensitivity for the photo-diode 6 is shown in Figure 2e.

The light-emitting diode 5 and the photo-diode 3 (see Fig. 1) shall be made of a material having a high trans-

- 4 -

perancy to light with the wavelength $\lambda_1$. The transmission curve for the light-emitting diode 5 and the photo-diode 3 is shown in Figure 2c. This means that the components shall be made of a semiconductor material with the band gap $E_g > \frac{hc}{\lambda_1}$, or that their active layers are very thin. On the other hand, the light-emitting diode 5 will emit light with a wavelength $\lambda_2 < \lambda_1$. The emission spectrum of the light-emitting diode 5 is shown in Figure 2b. The spectral sensitivity of the photo-diode 3 is shown in Figure 2d. This photo-diode shall be adapted such that its sensitivity becomes high at the wavelength $\lambda_2$.

Since the light-emitting diode 5 is made of a material with a greater band gap than the material included in the photo-diode 6, the output voltage from the diode 6 is not sufficient to provide a current through the light-emitting diode 5. The voltage from the photo-diode 6 must be raised, and this is done by making the photo-diode 6 in the form of several series-connected photo-diodes (not shown) or by including voltage doublers in the electronic circuit 7.

The light-emitting diode 2 and the photo-diode 6 may be manufactured by the normal, conventional technique of to-day and may /be given a variety of different embodiments. The condition that the light-emitting diode 5 and the photo-diode 3 shall be transparent places certain demands on their structure. Figure 3 shows a suitable structure of GaAs/GaAlAs. The structure is formed by superimposing on an n-doped substrate 9 of GaAs, first an n-doped layer 10 of GaAlAs and then a p-doped layer 11 of GaAlAs by liquid-phase epitaxy. The layer 11 is contacted with metal 13 and the whole structure is mounted on a glass or sapphire plate 12. Finally, an opening 22 is etched in the substrate 9 where the light guide fiber 4 is placed.

By choosing a sufficiently high Al-content in layers 10 and 11, the structure can be made transparent to light with the wavelength $\lambda_1$.

The method can, of course, be generalized to several parallel wavelength-multiplexed signals in either direction. Figure 4 shows such a system having two channels in either direction. One channel passes from the instrument side (left-hand side in Figure 1) to the transducer side (right-hand side in Figure 1) and consists of an light-emitting diode 14 and a photo-diode 21. The transducer side is on the right in Figure 4. The light wavelength at the transmission is $\lambda_1$. The light-emitting diode 15 and the photo-diode 20 form a channel with the light wavelength $\lambda_2$. The light-emitting diode 19 and the photo-diode 16 form a channel with the wavelength $\lambda_3$, and the light-emitting diode 18 and the photo-diode 17 finally form a channel with the wavelength $\lambda_4$. For the wavelengths the following applies: $\lambda_1 > \lambda_2 > \lambda_3 > \lambda_4$. The light-emitting diodes 15, 18 and 19 and the photo-diodes 16, 17 and 20 are transparent to light of the wavelength $\lambda_1$. The light-emitting diodes 18, 19 and the photo-diodes 16, 17 are transparent to light of the wavelength $\lambda_2$. The light-emitting diode 18 and the photo-diode 17 are transparent to light of the wavelength $\lambda_3$. During measurements, $\lambda_1$ can be used for transmitting the supply power, $\lambda_2$ for connecting a reference signal to the transducer, and $\lambda_3$ and $\lambda_4$ for transmitting two measuring signals.

The photo-diodes for power supply are positioned below the light-emitting diode for the measuring signal transmission according to Figure 3. The light-emitting diode can suitably be mounted on a plate of a transparent insulating material, for example glass or sapphire (see above). The photo-diodes for power supply are suitably integrated with the electronic circuit for coding the measuring signals. Couplings between the light-emitting diodes, the photo-diodes, and the electronic circuit for coding the measuring signal are made by bonding. The coupling between the light-emitting diodes and the photo-diodes on the one hand and the fiber on the other hand can be made with a lens system.

The measuring devices as described above can be varied in many ways within the scope of the general idea of the invention. The term "light" as used above refers to electromagnetic radiation also beyond the limits of the visible wavelength range. By "photo-diode" is meant a component sensitive to such radiation, and by "light-emitting diode" is meant a component which emits such radiation.

Patentanwalt und Rechtsanwalt
Dr.-Ing. Dipl.-Ing. Joachim B o e c k e r

6 Frankfurt / Main 1
Rathenauplatz 2 · 8
Telefon: (06 11) * 28 23 55
Telex: 4 189 066 itax d

**0041668**

, May 25, 1981

20 945 PE

- 7 -

## Claims:

1. Fiber optical measuring device with a transducer section (5, 6, 7) comprising an optically supplied electronic system (7), the supply power and the measuring signal being arranged to be transmitted on the same light guide fiber (4), the device comprising light-emitting diodes (2, 5) and photo-diodes (3, 6), characterized in that the light-emitting diode (5) for transmission of the measuring signal is transparent to the light wavelength ($\lambda_1$), which is used for supplying the photo-diode (6) for the power supply, and that this light-emitting diode (5) is located in the optical path between the end of the fiber (4) and the photo-diode (6) receiving the optical supply power, and/or that the photo-diode (3) for receiving the measuring signal is transparent to the light wavelength ($\lambda_1$) that is used for the supply power, this photo-diode (3) being positioned between the other end of the fiber (4) and the light-emitting diode (2) which emits the supply power.

2. Measuring device according to claim 1, characterized in that in order to arrange two or more parallel channels in the device for transmitting two or more signals to or from the transducer section, two or more light-emitting diodes (18, 19) are located between two or more photo-diodes (20, 21) for the power supply and the one end of the fiber (4) and the two or more photo-diodes (16, 17) are located between two or more light-emitting diodes (14, 15) and the other end of the fiber (4), and that each channel is arranged to work with a shorter wavelength ($\lambda_1, \lambda_2, \lambda_3, \lambda_4$) the closer to the fiber ends (4) the components are located, and that all the components which are located

/8

- 8 -

between the components of a channel which works with a certain wavelength are transparent to this wavelength.

3. Measuring device according to claim 1 or 2, characterized in that the light-emitting or photo-diodes are manufactured wholly or partially transparent to light of a certain wavelength by being made of a semiconductor material with a band gap $E_g > \frac{hc}{\lambda}$ (where h is Planck's constant, c is velocity of light and $\lambda$ is wavelength), for example by varying the Al-content in a semiconductor made of GaAlAs.

4. Measuring device according to any of the preceding claims, characterized in that the light-emitting and/or photo-diodes are made partially transparent by being made as thin structures (10, 11).

5. Measuring device according to claim 3 or 4, characterized in that the light-emitting and/or photo-diodes are made so that the active material has been applied on or grown on a substrate (9) and that an opening (22) has been etched/in the region where the light passes in the substrate through the transparent component, the properties of the component thus being substantially determined by the applied layers and being independent of the thickness and band gap of the substrate (9).

6. Measuring device according to any of the preceding claims, characterized in that in the ray path between the light-emitting diode and the photo-diode is arranged a transparent insulating material (12), for example glass, silicon dioxide, aluminium oxide or sapphire.

7. Measuring device according to any of the preceding claims, characterized in that the photo-diode or

- 9 -

diodes for power supply are located in the immediate vicinity of the light-emitting diode for the transmission of the measuring signal.

8. Measuring device according to any of the preceding claims, characterized in that the transformation from light to electric supply power is arranged by means of series-connected photo diodes, which may be integrated in one and the same semiconductor plate, laterally or applied on top of each other by epitoctic or MOCVD technique.

9. Measuring device according to claim 8, characterized in that the photo-diodes for power supply are integrated on the same semiconductor plate as the electronic circuit (7) for coding of the measuring signal.

10. Measuring device according to any of the preceding claims, characterized in that connections between the light-emitting diodes, the photo-diodes and the electronic circuit for coding the measuring signal are made by means of bonding and/or thick film and/or thin film technique.

11. Measuring device according to any of the preceding claims, characterized in that the coupling between the light-emitting diodes, the photo-diodes and the fiber (4) is made by means of a lens system.

/10

FIG. 1

FIG. 2

*FIG. 3*

4

22

9

n

10

11

N

P

A

A

12

13

*A - A*

*FIG. 4*

14  15  16  17

4

18  19  20  21

$\lambda_1$  $\lambda_2$  $\lambda_3$  $\lambda_4$